# EUROPEAN PATENT SPECIFICATION

(11) **EP 3 290 478 B1**
(45) Date of publication and mention of the grant of the patent: **29.07.2020**
(21) Application number: 16786697.9
(22) Date of filing: 22.04.2016
(51) Int. Cl.: C08L 69/00, C08L 51/04, C08L 67/08, C08L 63/00, C08K 3/00, C08K 5/00

(54) **THERMOPLASTIC RESIN COMPOSITION, AND ELECTRONIC DEVICE HOUSING COMPRISING SAME**
THERMOPLASTISCHE HARZZUSAMMENSETZUNG UND GEHÄUSE EINER ELEKTRONISCHEN VORRICHTUNG DAMIT
COMPOSITION DE RÉSINE THERMOPLASTIQUE, ET BOÎTIER DE DISPOSITIF ÉLECTRONIQUE LA COMPRENANT

(30) Priority: 30.04.2015 KR 20150062129
(43) Date of publication of application: 07.03.2018
(73) Proprietor: Lotte Advanced Materials Co., Ltd., Jeollanam-do 59616 (KR)
(72) Inventor: HA, Dong In, Uiwang-si Gyeonggi-do 16073 (KR); SHIN, Seung Shik, Uiwang-si Gyeonggi-do 16073 (KR); CHIN, Kyuong Sik, Uiwang-si Gyeonggi-do 16073 (KR)
(74) Representative: Michalski Hüttermann & Partner Patentanwälte mbB
(86) International application number: PCT/KR2016/004228
(87) International publication number: WO 2016/175511

(56) References cited:
- JP-A- 2014 152 245
- KR-A- 20100 077 267
- KR-A- 20150 002 262
- KR-B1- 100 810 111
- KR-B1- 100 856 747
- US-A- 4 554 315
- US-A1- 2006 205 895
- US-B2- 8 080 618

## Description

### Technical Field

The present invention relates to a thermoplastic resin composition and an electronic device housing including the same. More specifically, the present invention relates to a thermoplastic resin composition exhibiting good impact resistance, flowability, external appearance, flame resistance and the like, and an electronic device housing including the same.

### Background Art

Thermoplastic resin compositions exhibit good physical properties, such as low specific gravity, good moldability, and good impact resistance, as compared with glass or metal, and are useful for housings of electrical/electronic products, automotive interior/exterior materials, and exterior materials for construction. Particularly, with the trend of producing larger and lighter weight electrical/electronic products, plastic products using thermoplastic resins are quickly replacing existing glass or metal-based products.

KR 2015 0002262 A refers to components for vehicles, electric/electronic products, home appliances, office equipments or household items, which are manufactured using a high heat resistant polymer resin composition capable of providing an environmentally friendly biomass-containing synthetic resin which exhibits improved chemical resistance. Provided are components for vehicles, electric/electronic products, home appliances, office equipments or household items, which are manufactured using a high heat resistant polymer resin composition having excellent chemical resistance, the composition including a polyester copolymer containing a residue of a dicarboxylic acid component containing terephthalic acid and a residue of a diol component containing dianhydrohexitol; one or more copolymers selected from the group consisting of an unsaturated nitrile-diene-based rubber-aromatic vinyl graft copolymer, an alkylmethacrylate-diene-based rubber-aromatic vinyl graft copolymer, and an alkylmethacrylate-silicone/alkylacrylate graft copolymer; and polytrimethylene terephthalate.

JP 2014 152245 A refers to thermoplastic resin composition including: (A): a graft copolymerization body in which a rubbery polymer is grafted with at least one monomer selected from the group consisting of an aromatic vinyl monomer, a vinyl cyanide monomer and other copolymerizable monomers; (B): a polymerization body in which at least one monomer selected from the group consisting of an aromatic vinyl monomer, a vinyl cyanide monomer and other copolymerizable monomers is polymerized; and (C) an aromatic polycarbonate. In the thermoplastic resin composition, a graft ratio of the (A) component is 70-250%, when the total amount of these (A)-(C) components is assumed to be 100 mass%, the total content (X) of the (A) component and the (B) component is 10-50 mass%, and a content of the (C) component is 50-90 mass%.

US 8 080 618 B2 refers to thermoplastic resin composition with good heat stability, light stability and impact strength.In an exemplary embodiment, the thermoplastic resin composition comprises (A) about 10 to about 99 parts by weight of an epoxy group-containing styrenic resin; (B) about 1 to about 90 parts by weight of a polyester resin; (C) about 0.1 to about 10 parts by weight of a thermoplastic polyester resin comprising a cycloaliphatic diol such as cyclohexane dimethanol, per about 100 parts by weight of a base resin comprising (A)+(B); (D) about 0.05 to about 2 parts by weight of a hindered phenolic compound, per about 100 parts by weight of a base resin comprising (A)+(B); (E) about 0.05 to about 4 parts by weight of a phosphite compound, per about 100 parts by weight of a base resin comprising (A)+(B); and (F) about 0.2 to about 6 parts by weight of a compound comprising a HALS compound, benzotriazol based compound, or a combination thereof, per about 100 parts by weight of a base resin comprising (A)+(B).

Among the thermoplastic resin compositions, a polycarbonate/acrylonitrile-butadiene-styrene (PC/ABS) blend obtained by mixing a PC resin with a rubber-modified aromatic vinyl copolymer resin such as ABS may exhibit improved properties in terms of processability, chemical resistance and the like, without deterioration in impact resistance, heat resistance and the like, which may reduce production cost and enable a variety of applications.

In addition, as a multi-component material, adding an easily obtainable material such as a polyester resin to the PC/ABS blend in order to exhibit physical properties which are hardly found in typical thermoplastic resins are researched now.

However, adding a multi-component material to PC or ABS may cause a compatibility problem to deteriorate physical properties of the thermoplastic resin composition, such as impact resistance, flowability, external appearance and the like, and this problem needs to be solved.

One example of the related art is disclosed in Japanese Patent Laid-Open Publication No. 2014-152245.

### Disclosure

### Technical Problem

The present invention provides a thermoplastic resin composition exhibiting good impact resistance, flowability, external appearance, flame resistance and the like.

The present invention provides an electronic device housing produced from the thermoplastic resin composition.

The above and other objects of the present invention may be achieved by the present invention described below.

### Technical Solution

One aspect of the present invention relates to a thermoplastic resin composition comprising: 100 parts by weight of a polycarbonate resin; 1 to 30 parts by weight of a rubber-modified aromatic vinyl graft copolymer; 1 to 30 parts by weight of a polyester resin; 1 to 20 parts by weight a glycol-modified polyester resin having 10 mol% to 60 mol% of a cyclohexanedimethanol (CHDM) content based on a total amount of a diol component; and 0.5 to 15 parts by weight of a vinyl copolymer comprising an epoxy group, wherein a weight ratio of the polyester resin to the glycol-modified polyester resin ranges from 1:0.1 to 1:1.

In some embodiments, the rubber-modified aromatic vinyl graft copolymer may be obtained by graft copolymerization of an aromatic vinyl monomer and a monomer copolymerizable with the aromatic vinyl monomer onto a rubbery polymer.

In some embodiments, the polyester resin may include at least one of polyethylene terephthalate, polybutylene terephthalate, polyethylene naphthalate, polytrimethylene terephthalate, and polycyclohexylene terephthalate.

In some embodiments, the polyester resin may include a recycled polyester resin.

In some embodiments, the glycol-modified polyester resin may have 30 mol% to 60 mol% of a cyclohexanedimethanol (CHDM) content based on a total amount of a diol component.

In some embodiments, the vinyl copolymer including an epoxy group may be obtained by copolymerization of (meth)acrylate including an epoxy group, an aromatic vinyl monomer, and a monomer copolymerizable with the aromatic vinyl monomer.

In some embodiments, the vinyl copolymer including an epoxy group may include 0.01 mol% to 10 mol% of (meth)acrylate including an epoxy group.

In some embodiments, the thermoplastic resin composition may further include at least one of an inorganic filler, a flame retardant, a flame retardant aid, a release agent, a lubricant, a plasticizer, a heat stabilizer, a dripping inhibitor, an antioxidant, a light stabilizer, a pigment, and a dye.

In some embodiments, the thermoplastic resin composition may have a notched Izod impact strength of 392.3 N cm/cm (40 kgf·cm/cm) to 784.5 N cm/cm (80 kgf·cm/cm) as measured on an 3.175 mm (1/8") thick specimen in accordance with ASTM D256, and a melt flow index (MI) of 10 g/10 min to 20 g/10 min as measured at 260 °C under a load of 2.16 kg in accordance with ASTM D1238.

Another aspect of the present invention relates to an electronic device housing. The electronic device housing may include a metal frame; and a plastic member facing at least one face of the metal frame, wherein, the plastic member may be produced from the thermoplastic resin composition.

### Advantageous Effects

The present invention provides a thermoplastic resin composition exhibiting good impact resistance, flowability, external appearance, flame resistance and the like, and an electronic device housing including the same.

### Description of Drawings

FIG. 1 shows a schematic cross-section of an electronic device housing according to one embodiment of the present invention.
FIG. 2 shows a Scanning Electron Microscope (SEM) image of a thermoplastic resin composition specimen prepared in Example 1 of the present invention.
FIG. 3 shows a SEM image of a thermoplastic resin composition specimen prepared in Comparative Example 1 of the present invention.
FIG. 4 shows a SEM image of a thermoplastic resin composition specimen prepared in Comparative Example 2 of the present invention.
FIG. 5 shows a SEM image of a thermoplastic resin composition specimen prepared in Comparative Example 3 of the present invention.

### Best Mode

Hereinafter, embodiments of the present invention will be described in detail.

A thermoplastic resin composition according to the present invention may include (A) a polycarbonate resin; (B) a rubber-modified aromatic vinyl graft copolymer; (C) a polyester resin; (D) a glycol-modified polyester resin having 10 mol% to 60 mol% of a cyclohexanedimethanol (CHDM) content based on a total amount of a diol component; and a vinyl copolymer including an epoxy group.

### (A) Polycarbonate Resin

The polycarbonate resin used in the present invention may include any typical polycarbonate resin known in the art of thermoplastic resin composition. For example, the polycarbonate resin may include an aromatic polycarbonate resin prepared by reacting a precursor such as phosgene, halogen formate, and carbonate diester with diphenols (aromatic diol compounds).

Examples of the diphenols may include 4,4'-biphenol, 2,2-bis(4-hydroxyphenyl)propane, 2,4-bis(4-hydroxyphenyl)-2-methylbutane, 1,1-bis(4-hydroxyphenyl)cyclohexane, 2,2-bis(3-chloro-4-hydroxyphenyl)propane, 2,2-bis(3,5-dichloro-4-hydroxyphenyl)propane and the like, without being limited thereto. For example, 2,2-bis(4-hydroxyphenyl)propane, 2,2-bis(3,5-dicholro-4-hydroxyphenyl)propane, and 1,1-bis(4-hydroxyphenyl)cyclohexane may be used. Specifically, 2,2-bis(4-hydroxyphenyl)propane, which is also referred to as bisphenol-A, may be used.

The polycarbonate resin may include a branched polycarbonate resin, and may be prepared by adding 0.05 mol % to 2 mol % of a polyfunctional compound containing tri- or higher functional groups, for example, tri- or higher-valent phenol groups, based on the total amount of the diphenols used in polymerization.

The polycarbonate resin may be used in the form of a homo-polycarbonate resin, a co-polycarbonate resin, or a blend thereof.

In addition, the polycarbonate resin may be partially or completely replaced by an aromatic polyester-carbonate resin obtained by a polymerization reaction in the presence of an ester precursor, for example, a bifunctional carboxylic acid.

In exemplary embodiments, the polycarbonate resin may have a weight average molecular weight (Mw) of 10,000 g/mol to 200,000 g/mol, for example 15,000 g/mol to 40,000 g/mol, as measured by gel permeation chromatography (GPC), without being limited thereto.

In exemplary embodiments, the polycarbonate resin may have a melt flow index (MI) of 5 g/10 min to 40 g/10 min, as measured at 250 °C under a load of 10 kg in accordance with ISO 1133, without being limited thereto. In exemplary embodiments, the polycarbonate resin may include a mixture of at least two polycarbonate resins having different melt indices.

### (B) Rubber-modified aromatic vinyl graft copolymer

The rubber-modified aromatic vinyl graft copolymer used in the present invention may include a copolymer obtained by graft copolymerization of an aromatic vinyl monomer and a monomer copolymerizable with the aromatic vinyl monomer onto a rubbery polymer.

In exemplary embodiments, the rubber-modified aromatic vinyl graft copolymer may be obtained by adding an aromatic vinyl monomer, a monomer copolymerizable with the aromatic vinyl monomer and the like, to a rubbery polymer, with further inclusion of a monomer for imparting processability and heat resistance if necessary, followed by polymerization (graft copolymerization) thereof. The polymerization process may be performed by any polymerization method known in the art, such as emulsion polymerization, suspension polymerization, bulk polymerization and the like.

In exemplary embodiments, the rubbery polymer may include diene rubbers such as polybutadiene, poly(styrene-butadiene), poly(acrylonitrile-butadiene) and the like; saturated rubbers obtained by adding hydrogen to the diene rubbers; isoprene rubbers; acrylic rubbers such as poly(butyl acrylate); and ethylenepropylene-diene monomer terpolymers (EPDM), without being limited thereto. These can be used alone or in combinations thereof. For example, the rubbery polymer may include a diene rubber, specifically a butadiene based rubber. The rubbery polymer may be present in an amount of 5 wt% to 65 wt%, for example 10 wt% to 60 wt%, specifically 20 wt% to 50 wt%, based on the total weight (100 wt%) of the rubber-modified aromatic vinyl graft copolymer. Within this range, the thermoplastic resin composition may exhibit good impact resistance, mechanical properties and the like. The rubbery polymer (rubber particles) may have an average (Z-average) particle size of 0.05 µm to 6 µm, for example 0.15 µm to 4 µm, specifically 0.25 µm to 3.5 µm. Within this range, the thermoplastic resin composition may exhibit good impact resistance, external appearance, flame resistance and the like.

In exemplary embodiments, the aromatic vinyl monomer may include any aromatic vinyl monomer which is graft-copolymerizable with the rubbery copolymer. Examples of the aromatic vinyl monomer may include styrene, α-methylstyrene, β-methylstyrene, p-methylstyrene, p-t-butylstyrene, ethylstyrene, vinylxylene, monochlorostyrene, dichlorostyrene, dibromostyrene, vinylnaphthalene and the like, without being limited thereto. These can be used alone or in combinations thereof. The aromatic vinyl monomer may be present in an amount of 15 wt% to 94 wt%, for example 20 wt% to 80 wt%, specifically 30 wt% to 60 wt%, based on the total weight (100 wt%) of the rubber-modified aromatic vinyl graft copolymer. Within this range, the thermoplastic resin composition may exhibit good impact resistance, mechanical properties and the like.

In exemplary embodiments, the monomer copolymerizable with the aromatic vinyl monomer may include vinyl cyanide compounds such as acrylonitrile, methacrylonitrile, ethacrylonitrile, phenylacrylonitrile, α-cloroacrylonitrile, pumaronitirle and the like. These monomers can be used alone or in combinations thereof. The monomer copolymerizable with the aromatic vinyl monomer may be present in an amount of 1 wt% to 50 wt%, for example 5 wt% to 45 wt%, specifically 10 wt% to 30 wt%, based on the total weight of the rubber-modified aromatic vinyl graft copolymer. Within this range, the thermoplastic resin composition may exhibit good impact resistance, mechanical properties and the like.

In exemplary embodiments, the monomer for imparting processability and heat resistance may include acrylic acid, methacrylic acid, maleic anhydride, N-substituted maleimide and the like, without being limited thereto. These can be used alone or in combinations thereof. The monomer for imparting processability and heat resistance may be present in an amount of 15 wt% or less, for example 0.1 wt% to 10 wt%, based on the total weight of the rubber-modified aromatic vinyl graft copolymer. Within this range, processability, mechanical properties, flame resistance and the like of the thermoplastic resin composition may improve without deterioration in other properties.

In exemplary embodiments, the rubber-modified aromatic vinyl graft copolymer may be present in an amount of 1 to 30 parts by weight, for example 5 to 25 parts by weight, specifically 10 to 25 parts by weight, based on 100 parts by weight of the polycarbonate resin. Within this range, the thermoplastic resin composition may exhibit good impact resistance, mechanical properties and the like.

### (C) Polyester Resin

The polyester resin may resin used in the present invention may include any typical polyester resin known in the art of the thermoplastic resin composition, except for the glycol-modified polyester resin. For example, the polyester resin may be prepared by condensation polymerization of a dicarboxylic acid component and a diol component. Examples of the dicarboxylic acid component may include, without limitation, aromatic dicarboxylic acid such as terephthalic acid (TPA), isophthalic acid (IPA), 1,2-naphthalene dicarboxylic acid, 1,4-naphthalene dicarboxylic acid, 1,5-naphthalene dicarboxylic acid, 1,6-naphthalene dicarboxylic acid, 1,7-naphthalene dicarboxylic acid, 1,8-naphthalene dicarboxylic acid, 2,3-naphthalene dicarboxylic acid, 2,6-naphthalene dicarboxylic acid, 2,7-naphthalene dicarboxylic acid and the like; aromatic dicarboxylate such as dimethyl terephthalate (DMT), dimethyl isophthalate, dimethyl-1,2-naphthalate, dimethyl-1,5-naphthalate, dimethyl-1,7-naphthalate, dimethyl-1,7-naphthalate, dimethyl-1,8-naphthalate, dimethyl-2,3-naphthalate, dimethyl-2,6-naphthalate, dimethyl-2,7-naphthalate and the like. Examples of the diol component may include, without limitation, ethylene glycol, 1,2-propylene glycol, 1,3-propylene glycol, 2,2-dimethyl-1,3-propane diol, 1,3-butanediol, 1,4-butanediol, 1,5-pentanediol, 1,6-hexanediol and the like.

In exemplary embodiments, the polyester resin may include at least one of polyethylene terephthalate (PET), polybutylene terephthalate (PBT), polyethylene naphthalate (PEN), and polytrimethylene terephthalate (PTT).

In exemplary embodiments, the polyester resin may include a recycled polyester resin. For example, the recycled polyester resin may include a recycled polyethylene terephthalate (PET). This kind of recycled polyester resin may be directly crushed from a bottle, a sheet and the like which are made from a polyester resin, or the recycled polyester resin may re-extruded therefrom. The recycled polyester resin may be used in a form of a pellet, without being limited thereto. Use of the recycled polyester resin may be good for its eco-friendly effect.

In exemplary embodiments, the polyester resin may have an inherent viscosity of 0.4 dl/g to 1.5 dl/g, for example 0.5 dl/g to 1.2 dl/g, as measured at 35 °C using an o-chlorophenol solution (concentration: 0.5 g/dl). Within this range, the thermoplastic resin composition may exhibit good heat resistance, mechanical strength, flowability and the like.

In exemplary embodiments, the polyester resin may be present in an amount of 1 to 30 parts by weight, for example 5 to 25 parts by weight, specifically 10 to 20 parts by weight, based on 100 parts by weight of the polycarbonate resin. Within this range, the thermoplastic resin composition may exhibit good heat resistance, mechanical strength, flowability and the like.

### (D) Glycol-modified polyester resin

The glycol-modified polyester resin used in the present invention may include a polyester resin having 10 mol% to 60 mol% of a 1,4-cyclohexanedimethanol (CHDM) content based on a total amount of a diol component. The glycol-modified polyester resin may improve miscibility of the components of the thermoplastic resin composition to enable the polyester resin, the rubber-modified aromatic vinyl graft copolymer and the like are uniformly dispersed in a matrix (polycarbonate resin) in small sizes. The glycol-modified polyester resin may also inhibit increase of the degree of crystallization of the polyester resin to reduce post-deformation and post-shrinkage of a product molded from the thermoplastic resin composition.

In exemplary embodiments, the glycol-modified polyester resin may be prepared by condensation polymerization of a dicarboxylic acid component and a diol component. Examples of the dicarboxylic acid component may include terephthalic acid, and examples of the diol component may include a mixture including 40 mol% to 90 mol%, for example 40 mol% to 70 mol% of C₂-C₆ alkylene glycol and 10 mol% to 60 mol%, for example 30 mol% to 60 mol% of 1,4-cyclohexanedimethanol (CHDM). Within this range, the aforementioned effects may be obtained.

In exemplary embodiments, the glycol-modified polyester resin may have an inherent viscosity of 0.5 dl/g to 0.7 dl/g, for example 0.55 dl/g to 0.65 dl/g, as measured at 35 °C using an o-chlorophenol solution (concentration: 0.5 g/dl). Within this range, miscibility of the components of the thermoplastic resin composition may improve, and the thermoplastic resin composition may exhibit good impact resistance, flowability, dimensional stability, external appearance and the like.

In exemplary embodiments, the glycol-modified polyester resin may be present in an amount of 1 to 20 parts by weight, for example 2 to 18 parts by weight, specifically 5 to 15 parts by weight, based on 100 parts by weight of the polycarbonate resin. Within this range, miscibility of the components of the thermoplastic resin composition may improve, and the thermoplastic resin composition may exhibit good impact resistance, flowability, dimensional stability, external appearance and the like.

A weight ratio of the polyester resin to the glycol-modified polyester resin may range from 1:0.1 to 1:1, for example 1:0.3 to 1:0.7. Within this range, miscibility of the components of the thermoplastic resin composition may further improve.

### (E) Vinyl copolymer including an epoxy group

The vinyl copolymer including an epoxy group used in the present invention may improve miscibility of the components of the thermoplastic resin composition, together with the glycol-modified polyester resin. The vinyl copolymer including an epoxy group may enable a uniform dispersion of the polyester resin, the rubber-modified aromatic vinyl graft copolymer and the like in a matrix (polycarbonate resin) to greatly improve physical properties of each component of the thermoplastic resin composition.

In exemplary embodiments, the vinyl copolymer including an epoxy group may be prepared by copolymerization of (meth)acrylate including an epoxy group, an aromatic vinyl monomer, and a monomer copolymerizable with the aromatic vinyl monomer.

In exemplary embodiments, the vinyl copolymer including an epoxy group may be obtained by mixing (meth)acrylate including an epoxy group, an aromatic vinyl monomer, and a monomer copolymerizable with the aromatic vinyl monomer, followed by polymerization thereof. The polymerization process may be performed by any polymerization method known in the art, such as emulsion polymerization, suspension polymerization, bulk polymerization and the like.

In exemplary embodiments, examples of the (meth)acrylate including an epoxy group may include glycidyl methacrylate, glycidyl acrylate and the like, without being limited thereto. These can be used alone or in combinations thereof. The (meth)acrylate including an epoxy group may be present in an amount of 0.01 wt% to 10 wt%, for example 0.05 wt% to 5 wt%, specifically 0.1 mol% to 1 mol%, based on the total weight (100 wt%) of the vinyl copolymer including an epoxy group. Within this range, miscibility of each component of the thermoplastic resin composition may improve.

In exemplary embodiments, the aromatic vinyl monomer may include styrene, α-methylstyrene, β-methylstyrene, p-methylstyrene, p-t-butylstyrene, ethylstyrene, vinylxylene, monochlorostyrene, dichlorostyrene, dibromostyrene, vinylnaphthalene and the like, without being limited thereto. These can be used alone or in combinations thereof. The aromatic vinyl monomer may be present in an amount of 20 wt% to 90 wt%, for example 30 wt% to 60 wt%, based on the total weight (100 wt%) of the vinyl copolymer including an epoxy group. Within this range, miscibility of each component of the thermoplastic resin composition may improve.

In exemplary embodiments, the monomer copolymerizable with the aromatic vinyl monomer may include vinyl cyanide compounds, such as acrylonitrile, methacrylonitrile, ethacrylonitrile, phenylacrylonitrile, α-cloroacrylonitrile, pumaronitirle and the like. These can be used alone or in combinations thereof. The monomer copolymerizable with the aromatic vinyl monomer may be present in an amount of 5 wt% to 70 wt%, for example 10 to 50 wt%, based on the total weight (100 wt%) of the vinyl copolymer including an epoxy group. Within this range, miscibility of each component of the thermoplastic resin composition may improve.

In exemplary embodiments, the vinyl copolymer including an epoxy group may be present in an amount of 0.5 to 15 parts by weight, for example 1 to 13 parts by weight, specifically 1 to 10 parts by weight, based on 100 parts by weight of the polycarbonate resin. Within this range, miscibility of the components of the thermoplastic resin composition may improve, and the thermoplastic resin composition may have good impact resistance, flowability, dimensional stability, external appearance and the like.

In exemplary embodiments, a weight ratio of the glycol-modified polyester resin to the vinyl copolymer including an epoxy resin may range from 1:1 to 15:1, without being limited thereto.

In addition, the thermoplastic resin composition according to embodiments of the present invention may further include an additive such as an inorganic filler, a flame retardant, a flame retardant aid, a release agent, a lubricant, a plasticizer, a heat stabilizer, a dripping inhibitor, an antioxidant, a light stabilizer, a pigment, a dye, and mixtures thereof.

In exemplary embodiments, any additive known in the art of the thermoplastic resin composition may be used without limitation. Examples of the inorganic filler may include glass fibers, wollastonite, whiskers, basalt fibers, talc, mica, without being limited thereto. For example, the inorganic filler may be present in an amount of 0.1 to 10 parts by weight, for example 0.5 to 5 parts by weight, based on 100 parts by weight of the polycarbonate resin. Within this range, the polycarbonate resin composition may exhibit good external appearance, mechanical properties, dimensional stability, flame resistance and the like.

Examples of an additive except for the inorganic filler may include a flame retardant such as red phosphorus, phosphate compounds, phosphonate compounds, phosphinate compounds, phosphine oxide compounds, phosphazene compounds and metal salts thereof; a release agent such as polyethylene wax, fluorine-containing polymer, silicon oil, metal salts of stearic acid, metal salts of montanic acid, montanic ester wax and the like; a nucleating agent such as clay and the like; an antioxidant such as hindered phenol compounds and the like; and mixtures thereof, without being limited thereto. The additive except for the inorganic filler may be present in an amount of 0.1 to 40 parts by weight based on 100 parts by weight of the polycarbonate resin, without being limited thereto.

The thermoplastic resin composition according to embodiments of the present invention may be prepared in a pellet form by mixing the above described components, followed by melt extrusion of the mixture at 200 °C to 280 °C, for example 250 °C to 260 °C, through a typical twin-screw extruder.

In exemplary embodiments, the thermoplastic resin composition may have a notched Izod impact strength of 392.3 N cm/cm (40 kgf·cm/cm) to 784.5 N cm/cm (80 kgf·cm/cm), for example 441.3 N cm/cm (45 kgf·cm/cm) to 588.4 N cm/cm (60 kgf·cm/cm), as measured on an 3.175 mm (1/8") thick specimen in accordance with ASTM D256. The thermoplastic resin composition may have a melt flow index (MI) of 10 g/10 min to 25 g/10 min, for example 12 g/10 min to 19 g/10 min, as measured at 260 °C under a load of 2.16 kg in accordance with ASTM D1238.

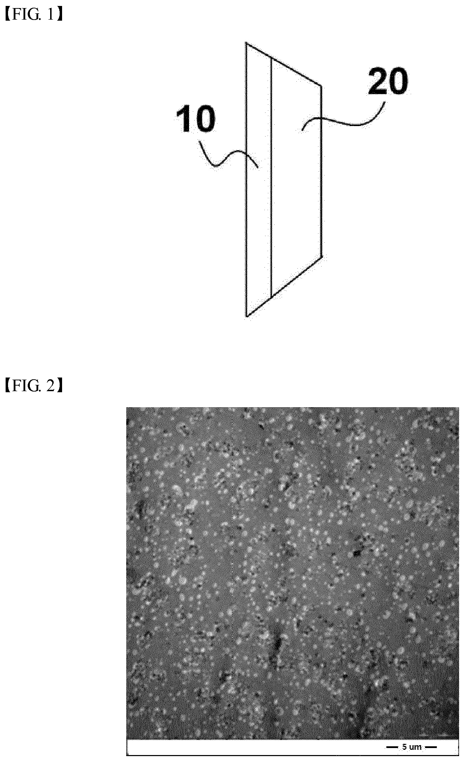

Fig. 1 shows a schematic cross-section of an electronic device housing according to one embodiment of the present invention. In the drawings, the dimensions of components may be exaggerated for clarity of illustration, and the drawings are provided for illustration only and are not to be construed in any way as limiting the present invention. As shown in Fig. 1, the electronic device housing according to one embodiment of the present invention may have a metal frame 10; and a plastic member 20 facing at least one face of the metal frame 10. The plastic member 20 may be produced from the above described thermoplastic resin composition.

In exemplary embodiments, the metal frame 10 and the plastic member 20 may have a variety of shapes without being limited to the drawing. However, at least one face of the metal frame 10 may face at least one face of the plastic member 20. The faced structure may be embodied by adhesion, insertion and the like, without being limited thereto.

In exemplary embodiments, the metal frame 10 may include a stainless-steel frame and the like typically used in electronic device housings including the plastic member. The metal frame 10 may be easily obtainable in commercial markets.

In exemplary embodiments, the plastic member 20 may be produced from the polycarbonate resin composition through a variety of molding methods such as injection molding, extrusion molding, vacuum molding, casting molding and the like. For example, the plastic member 20 may be used in a front cover, a rear cover and the like of a television, a monitor and the like having a size of 22 inches to 70 inches.

In exemplary embodiments, a coefficient of thermal expansion (CTE) difference between the metal frame and the plastic member may range from 0.1 to 0.5, for example 0.3 to 0.45.

### Mode for Invention

Hereinafter, the present invention will be described in more detail with reference to some examples. It should be understood that these examples are provided for illustration only and are not to be construed in any way as limiting the present invention. Descriptions of details apparent to those skilled in the art will be omitted for clarity.

### EXAMPLE

Details of components used in the following Examples and Comparative Examples are as follows.

### (A) Polycarbonate resin

(A1) Bisphenol-A based polycarbonate resin (Melt flow index as measured at 250°C under a load of 10kg in accordance with ISO 1133: 10.5±0.5 g/10 min) was used.
(A2) Bisphenol-A based polycarbonate resin (Melt flow index as measured at 250°C under a load of 10kg in accordance with ISO 1133: 30.0±0.5 g/10 min) was used.

### (B) Rubber-modified aromatic vinyl graft copolymer

g-ABS obtained by graft copolymerization of 55 wt% of a mixture of styrene and acrylonitrile (weight ratio 73:27) to 45 wt% of polybutadiene rubber (PBR) having Z-average of 310 nm was used.

### (C) Polyester Resin

Recycled polyethylene terephthalate (Polycom, Inc., Product name: PETR 10, intrinsic viscosity: 0.6 to 0.8 dl/g) was used.

### (D) Glycol-modified polyester resin

Glycol-modified polyethylene terephthalate (PMT International Co., Ltd., Product name: PTGR10/20) having 45 mol% of a cyclohexanedimethanol (CHDM) content based on a total amount of a diol component was used.

### (E) Vinyl copolymer including an epoxy group

Glycidylmethacrylate-styrene-acrylonitrile copolymer (GMA-SAN, prepared from polymerization of 1 mol% of glycidylmethacrylate and 99 mol% of a mixture of styrene and acrylonitrile (mole ratio 85:15)) was used.

### Examples 1 to 3 and Comparative Examples 1 to 3

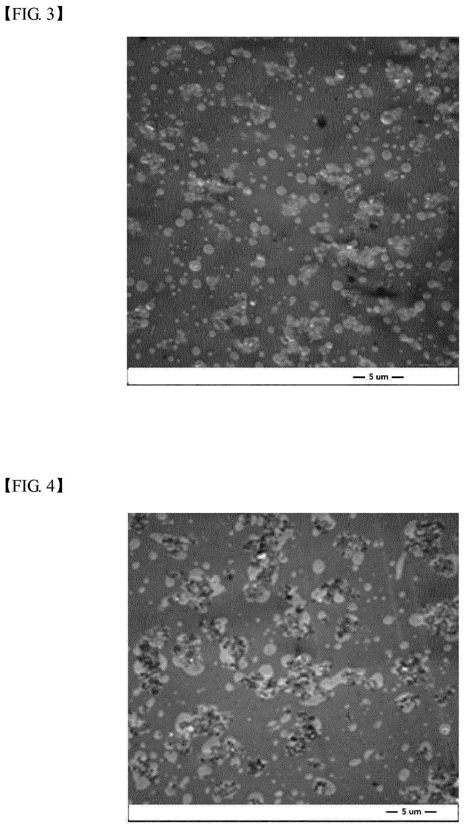

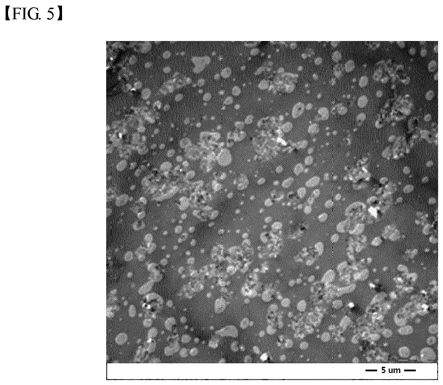

The aforementioned components were added in amounts as listed in Table 1, followed by extrusion at 250 °C to prepare pellets. Extrusion was performed using a twin-screw extruder (L/D=36, diameter 45 mm) and the prepared pellets were dried at 80 °C to 100°C for 4 hours or more and subjected to injection molding in a 6 Oz molding machine (molding temperature: 280 °C, mold temperature: 60 °C) to prepare specimens. The prepared specimens were evaluated as to the following properties and the results are shown in Table 1. Scanning Electron Microscope (SEM) images of the specimens of the thermoplastic resin compositions prepared in Example 1 and Comparative Examples 1, 2 and 3 are shown in Figs. 2, 3, 4 and 5, respectively.

### Property Evaluation

(1) Notched Izod impact strength unit N cm/cm (unit: kgf·cm/cm): Notched Izod impact strength was measured on a 3.175 mm (1/8") thick notched Izod specimen in accordance with ASTM D256.
(2) Melt flow index (MI, unit: g/10 min): Melt flow index was measured at 260 °C under a load of 2.16 kg in accordance with ASTM D1238.

**Table 1**

| | | Example | | | Comparative Example | | |
|---|---|---|---|---|---|---|---|
| | | 1 | 2 | 3 | 1 | 2 | 3 |
| (A) | (A1) (wt %) | 32.8 | 32.8 | 32.8 | 32.8 | 32.8 | 32.8 |
| | (A2) (wt%) | 67.2 | 67.2 | 67.2 | 67.2 | 67.2 | 67.2 |
| (B) (parts by weight) | | 21.9 | 21.9 | 21.9 | 21.9 | 21.9 | 21.9 |
| (C) (parts by weight) | | 20.3 | 20.3 | 20.3 | 20.3 | 20.3 | 20.3 |
| (D) (parts by weight) | | 10.9 | 10.9 | 10.9 | 10.9 | - | - |
| (E) (parts by weight) | | 1.6 | 4.7 | 7.8 | - | 4.7 | - |
| Notched Izod impact strength N cm/cm (kgf·cm/cm) | | 55 | 50 | 46 | 56 | 15 | 16 |
| Melt flow index (g/10 min) | | 13.8 | 14.2 | 16.0 | 13.3 | 15.2 | 14.5 |

| | | | | | | | |
|---|---|---|---|---|---|---|---|
| * Parts by weight: parts by weight based on 100 parts by weight of (A) polycarbonate resin | | | | | | | |

From Table 1 and Figs. 2, 3, 4 and 5, it can be seen that in each of the thermoplastic resin compositions according to the present invention, components such as the polyester resin, the rubber-modified aromatic vinyl graft copolymer and the like are uniformly dispersed in the polycarbonate resin matrix, and the thermoplastic resin compositions according to the present invention all have good impact resistance, flowability, external appearance, flame resistance and the like.

Conversely, the thermoplastic resin compositions of Comparative Examples 1 to 3 have large domains and low dispersities compared to the thermoplastic resin compositions of Examples 1 to 3. In addition, flowability (as in Comparative Example 1) or impact resistance (as in Comparative Examples 2 and 3) of each thermoplastic composition is deteriorated.

## Claims

1. A thermoplastic resin composition comprising:
100 parts by weight of a polycarbonate resin;
1 to 30 parts by weight of a rubber-modified aromatic vinyl graft copolymer;
1 to 30 parts by weight of a polyester resin;
1 to 20 parts by weight a glycol-modified polyester resin having 10 mol% to 60 mol% of a cyclohexanedimethanol content based on a total amount of a diol component; and
0.5 to 15 parts by weight of a vinyl copolymer comprising an epoxy group,
wherein a weight ratio of the polyester resin to the glycol-modified polyester resin ranges from 1:0.1 to 1:1.

2. The thermoplastic resin composition according to claim 1, wherein the rubber-modified aromatic vinyl graft copolymer is obtained by graft copolymerization of an aromatic vinyl monomer and a monomer copolymerizable with the aromatic vinyl monomer onto a rubbery polymer.

3. The thermoplastic resin composition according to claim 1, wherein the polyester resin comprises at least one of polyethylene terephthalate, polybutylene terephthalate, polyethylene naphthalate, polytrimethylene terephthalate, and polycyclohexylene terephthalate.

4. The thermoplastic resin composition according to claim 1, wherein the polyester resin comprises a recycled polyester resin.

5. The thermoplastic resin composition according to claim 1, wherein the glycol-modified polyester resin has 30 mol% to 60 mol% of a cyclohexanedimethanol (CHDM) content based on a total amount of a diol component.

6. The thermoplastic resin composition according to claim 1, wherein the vinyl copolymer comprising an epoxy group is obtained by copolymerization of (meth)acrylate comprising an epoxy group, an aromatic vinyl monomer, and a monomer copolymerizable with the aromatic vinyl monomer.

7. The thermoplastic resin composition according to claim 1, wherein the vinyl copolymer comprising an epoxy group comprises 0.01 mol% to 10 mol% of (meth)acrylate comprising an epoxy group.

8. The thermoplastic resin composition according to claim 1, further comprising at least one of an inorganic filler, a flame retardant, a flame retardant aid, a release agent, a lubricant, a plasticizer, a heat stabilizer, a dripping inhibitor, an antioxidant, a light stabilizer, a pigment, and a dye.

9. The thermoplastic resin composition according to claim 1, wherein the thermoplastic resin composition has a notched Izod impact strength of 392.3 N cm/cm (40 kgf·cm/cm) to 784.5 N cm/cm (80 kgf·cm/cm) as measured on a 3.175 mm (1/8") thick specimen in accordance with ASTM D256, and a melt flow index (MI) of 10 g/10 min to 25 g/10 min as measured at 260 °C under a load of 2.16 kg in accordance with ASTM D1238.

10. An electronic device housing comprising:
a metal frame; and
a plastic member facing at least one face of the metal frame,
wherein the plastic member is produced from the thermoplastic resin composition according to any one of claims 1 to 9.

## Patentansprüche

1. Thermoplastische Harzzusammensetzung, umfassend:
100 Gewichtsteile eines Polycarbonatharzes,
1 bis 30 Gewichtsteile eines kautschukmodifizierten vinylaromatischen Pfropfcopolymers,
1 bis 30 Gewichtsteile eines Polyesterharzes,
1 bis 20 Gewichtsteile eines glykolmodifizierten Polyesterharzes mit einem Cyclohexandimethanol-Gehalt von 10 Mol-% bis 60 Mol-%, bezogen auf die Gesamtmenge der Diolkomponente, und
0,5 bis 15 Gewichtsteile eines Vinylcopolymers mit einer Epoxidgruppe,
wobei das Gewichtsverhältnis von Polyesterharz zu glykolmodifiziertem Polyesterharz im Bereich von 1:0,1 bis 1:1 liegt.

2. Thermoplastische Harzzusammensetzung nach Anspruch 1, wobei das kautschukmodifizierte vinylaromatische Pfropfcopolymer durch Pfropfcopolymerisation eines vinylaromatischen Monomers und eines mit dem vinylaromatischen Monomer copolymerisierbaren Monomers auf ein kautschukartiges Polymer erhalten wird.

3. Thermoplastische Harzzusammensetzung nach Anspruch 1, wobei das Polyesterharz Polyethylenterephthalat, Polybutylenterephthalat, Polyethylennaphthalat, Polytrimethylenterephthalat und/oder Polycyclohexylenterephthalat umfasst.

4. Thermoplastische Harzzusammensetzung nach Anspruch 1, wobei das Polyesterharz ein rezykliertes Polyesterharz umfasst.

5. Thermoplastische Harzzusammensetzung nach Anspruch 1, wobei das glykolmodifizierte Polyesterharz einen Cyclohexandimethanol(CHDM)-Gehalt von 30 Mol-% bis 60 Mol-%, bezogen auf die Gesamtmenge der Diolkomponente, aufweist.

6. Thermoplastische Harzzusammensetzung nach Anspruch 1, wobei das Vinylcopolymer mit einer Epoxidgruppe durch Copolymerisation von (Meth)acrylat mit einer Epoxidgruppe, einem vinylaromatischen Monomer und einem mit dem aromatischen Vinylmonomer copolymerisierbaren Monomer erhalten wird.

7. Thermoplastische Harzzusammensetzung nach Anspruch 1, wobei das Vinylcopolymer mit einer Epoxidgruppe 0,01 Mol-% bis 10 Mol-% (Meth)acrylat mit einer Epoxidgruppe umfasst.

8. Thermoplastische Harzzusammensetzung nach Anspruch 1, ferner umfassend einen anorganischen Füllstoff, ein Flammschutzmittel, ein Flammschutzmittel-Hilfsmittel, ein Trennmittel, ein Schmiermittel, einen Weichmacher, einen Wärmestabilisator, ein Antiabtropfmittel, ein Antioxidans, ein Lichtschutzmittel, ein Pigment und/oder einen Farbstoff.

9. Thermoplastische Harzzusammensetzung nach Anspruch 1, wobei die thermoplastische Harzzusammensetzung eine Izod-Kerbschlagzähigkeit von 392,3 N cm/cm (40 kgf·cm/cm) bis 784,5 cm/cm (80 kgf·cm/cm) gemäß Messung an einem 3,175 mm (1/8 Zoll) dicken Prüfkörper gemäß ASTM D256 und einem Schmelzindex (MI) von 10 g/10 min bis 25 g/10 min gemäß Messung bei 260 °C unter einer Last von 2,16 kg gemäß ASTM D1238.

10. Gehäuse für eine elektronische Vorrichtung, umfassend:
einen Metallrahmen und
ein Kunststoffelement, das mindestens einer Seite des Metallrahmens zugewandt ist,
wobei das Kunststoffelement aus der thermoplastischen Harzzusammensetzung nach einem der Ansprüche 1 bis 9 hergestellt ist.

## Revendications

1. Composition de résine thermoplastique comprenant :
100 parties en poids d'une résine de polycarbonate ;
1 à 30 parties en poids d'un copolymère vinylaromatique greffé modifié par un caoutchouc ;
1 à 30 parties en poids d'une résine de polyester ;
1 à 20 parties en poids d'une résine de polyester modifiée par un glycol contenant 10 %mol à 60 %mol d'un cyclohexanediméthanol relativement à une quantité totale d'un constituant diol ; et
0,5 à 15 parties en poids d'un copolymère vinylique comprenant un groupe époxy,
dans lequel un rapport pondéral de la résine de polyester contre la résine de polyester modifiée par un glycol est de 1:0,1 à 1:1.

2. Composition de résine thermoplastique selon la revendication 1, dans laquelle le copolymère vinylaromatique greffé modifié par un caoutchouc est obtenu par copolymérisation par greffe d'un monomère vinylaromatique et d'un monomère copolymérisable avec le monomère vinylaromatique sur un polymère caoutchouteux.

3. Composition de résine thermoplastique selon la revendication 1, dans laquelle la résine de polyester comprend au moins l'un du téréphtalate de polyéthylène, du téréphtalate de polybutylène, du naphtalate de polyéthylène, du téréphtalate de polytriméthylène, et du téréphtalate de polycyclohexylène.

4. Composition de résine thermoplastique selon la revendication 1, dans laquelle la résine de polyester comprend une résine de polyester recyclée.

5. Composition de résine thermoplastique selon la revendication 1, dans laquelle la résine de polyester modifiée par un glycol contient 30 %mol à 60 %mol d'un cyclohexanediméthanol (CHDM) relativement à une quantité totale d'un constituant diol.

6. Composition de résine thermoplastique selon la revendication 1, dans laquelle le copolymère vinylique comprenant un groupe époxy est obtenu par copolymérisation d'un (méth)acrylate comprenant un groupe époxy, d'un monomère vinylaromatique, et d'un monomère copolymérisable avec le monomère vinylaromatique.

7. Composition de résine thermoplastique selon la revendication 1, dans laquelle le copolymère vinylique comprenant un groupe époxy comprend 0,01 %mol à 10 %mol d'un (méth)acrylate comprenant un groupe époxy.

8. Composition de résine thermoplastique selon la revendication 1, comprenant en outre au moins l'un d'une charge inorganique, d'un retardateur de flamme, d'un adjuvant ignifugeant, d'un agent anti-adhérent, d'un lubrifiant, d'un plastifiant, d'un stabilisant à la chaleur, d'un agent anti-égouttement, d'un antioxydant, d'un stabilisant à la lumière, d'un pigment, et d'un colorant.

9. Composition de résine thermoplastique selon la revendication 1, la composition de résine thermoplastique ayant une résistance aux chocs Izod sur barreau entaillé de 392,3 N cm/cm (40 kgf• cm/cm) à 784,5 N cm/cm (80 kgf• cm/cm) telle que mesurée sur une éprouvette de 3,175 mm (1/8") d'épaisseur selon ASTM D256, et un indice d'écoulement à l'état fondu (IF) de 10 g/10 min à 25 g/10 min tel que mesuré à 260 °C sous une charge de 2,16 kg selon ASTM D1238.

10. Boîtier de dispositif électronique comprenant :
un cadre métallique ; et
un élément en plastique orienté vers au moins une face du cadre métallique,
dans lequel l'élément en plastique est produit à partir de la composition de résine thermoplastique selon l'une quelconque des revendications 1 à 9.
